# EUROPÄISCHE PATENTANMELDUNG

(11) **EP 4 510 391 A1**
(43) Veröffentlichungstag der Anmeldung: **19.02.2025**
(21) Anmeldenummer: 24189849.3
(22) Anmeldetag: 19.07.2024
(51) Int. Cl.: H01R 13/6466, H05K 1/16, H01R 24/64, H01R 4/2433

(54) **ELEKTRISCHER VERBINDER FÜR EIN DATEN- ODER KOMMUNIKATIONSKABEL**

(30) Priorität: 15.08.2023 DE 102023121768
(71) Anmelder: METZ CONNECT TECH GmbH, 78176 Blumberg (DE)
(72) Erfinder: Merk, Benjamin, 78176 Blumberg (DE)
(74) Vertreter: Westphal, Mussgnug & Partner Patentanwälte mbB

(57) **Zusammenfassung**

Elektrischer Verbinder (1) für ein Daten- oder Kommunikationskabel mit folgenden Merkmalen:
- einem Gehäuse (3),
- einer Platine (50), wobei die Platine (50) zumindest teilweise im Gehäuse (3) angeordnet ist,
- die Platine (50) weist mindestens eine differentielle Leitung (53) auf,
- die differentielle Leitung (53) weist eine erste Leiterbahn (51) und eine zweite Leiterbahn (52) auf,
- die erste (51) und zweite Leiterbahn (52) weisen jeweils einen Leitungspfad (57) und erste Kontaktpads (54) und zweite Kontaktpads (55) an den Enden des Leitungspfades (57) auf,
- die zweiten Kontaktpads (55) sind mit zweiten Kontaktelementen (65) elektrisch verbunden,
- mindestens eine Kapazitätsplatte (91) ist auf der Platine (50) ausgebildet,

gekennzeichnet durch die weiteren Merkmale:
- eine einzige Kapazitätsplatte (91) ist zumindest teilweise überlappend mit einem der zweiten Kontaktelemente (65) auf der Platine (50) ausgebildet, wobei die Kapazitätsplatte (91) nicht mit dem überlappenden zweiten Kontaktelement (65) elektrisch verbunden ist.

## Beschreibung

Die Erfindung betrifft einen elektrischen Verbinder gemäß den Merkmalen des Oberbegriffs des Anspruchs 1.

In elektrischen Verbindern, insbesondere im Bereich der Hochfrequenztechnik weisen, Leitungen und Steckkontakte eine frequenzabhängige elektromagnetische Kopplung, insbesondere eine kapazitive Kopplung, zueinander auf. Infolgedessen kommt es zu ungewolltem Übersprechen zwischen Leitungen oder Steckkontakten. Gerade in Hochfrequenzanwendungen führt das Übersprechen zu Übertragungseinbußen. Um das unerwünschte Übersprechen so weit wie möglich zu kompensieren, werden Kondensatoren so geschaltet, dass das Übersprechsignal negiert wird. Dabei ist es vorteilhaft, die Kondensatoren so nahe wie möglich an dem Ort des Übersprechens anzuordnen.

Ein Steckverbinder, in dem Kondensatoren in der Nähe der Steckkontakte angeordnet sind, ist beispielsweise aus WO2017132697A1 bekannt.

Nachteilig ist, dass bei bestehenden Produkten häufig im Bereich der Steckkontakte der Bauraum gerade so ausreicht, um Kondensatoren anzuordnen. Möchte man den elektrischen Verbinder kompakter ausgestalten, so ist häufig kein Bauraum für Kondensatoren im Bereich der Steckkontakte vorhanden. Der für die Kompensation benötigte Kapazitätswert ist zudem gering, weswegen eine Anordnung eines Plattenkondensators innerhalb der Platine aufgrund der großen leitenden Platten, die sich in einem geringen Abstand gegenüberliegen, schnell zu groß ist. Eine Verwendung von kleineren Platten ist nachteilig, da dadurch die Ätztoleranzen deutlich mehr ins Gewicht fallen, da diese vom verwendeten Herstellungsprozess und nicht von der Größe der Platten, abhängig sind. Damit ist es vorteilhaft, wenn die Platten eine gewisse Mindestgröße aufweisen, und so den Einfluss der Ätztoleranzen zu minimieren. Das Zusammenspiel aus Platzproblemen sowie Anforderungen an die Mindestgröße der Kondensatorplatten sind problembehaftet.

Dieses Problem wird durch einen elektrischen Verbinder mit den Merkmalen des Patentanspruchs 1 gelöst.

Vorteilhafte Ausgestaltungen und Weiterbildungen der Erfindung sind in den abhängigen Ansprüchen angegeben.

Erfindungsgemäß ist demnach ein elektrischer Verbinder für ein Daten- oder Kommunikationskabel mit einem Gehäusevorgesehen sowie mit einer Platine, wobei die Platine zumindest teilweise in einem Gehäuse angeordnet ist und die Platine mindestens eine differentielle Leitung aufweist. Die differentielle Leitung weist eine erste Leiterbahn und eine zweite Leiterbahn auf, wobei die erste und zweite Leiterbahn jeweils einen Leitungspfad und Kontaktpads an den Enden des Leitungspfades aufweisen. Die Kontaktpads sind mit Kontaktelementen elektrisch verbunden, wobei mindestens eine Kapazitätsplatte auf der Platine ausgebildet ist. Erfindungsgemäß ist eine einzige Kapazitätsplatte zumindest teilweise überlappend mit einem der Kontaktelemente auf der Platine ausgebildet ist, wobei die Kapazitätsplatte nicht mit dem überlappenden zweiten Kontaktelement elektrisch verbunden ist.

Dadurch dass lediglich eine Kapazitätsplatte zur Kompensation eingesetzt wird, kann diese vorzugsweise auf einer der mittleren Platinenlagen angeordnet sein, wodurch der normativ vorgeschriebene Abstand zu den zweiten Kontaktpads eingehalten wird. Damit ist die Kapazitätsplatte ausreichend groß ausbildbar, um die Ätztoleranzen klein gegenüber der Fläche der Platten zu halten. Zudem ist durch den großen Abstand zum überlappenden zweiten Kontaktelement, der Kapazitätswert der Kapazitätsanordnung klein genug ausbildbar.

Die Kontaktelemente sind in erste und zweite Kontaktelemente unterteilbar, wobei die ersten Kontaktelemente vorzugsweise als Schneidklemmen und die zweiten Kontaktelemente als Stecckontakte ausgebildet sind. Die Kontaktpads sind in erste und zweite Kontaktpads unterteilbar, wobei die ersten Kontaktelemente direkt mit den ersten Kontaktpads verbunden sind, und wobei die zweiten Kontaktelemente direkt mit den zweiten Kontaktpads verbunden sind. Die ersten und zweiten Kontaktpads sind um erste und zweite Durchführöffnungen herum ausgebildet. Ein Kontaktpad kann auf mehreren Platinenlagen ausgebildet sein. Die Durchführöffnungen sind an den Seitenflächen verkupfert, wobei diese verkupferten Seitenflächen die einzelnen Ebenen des Kontaktpads miteinander verbinden und Teil eines Kontaktpads ist. Die Kontaktpads können die Form eines Kreises, eines Ovals, eines Vierecks aufweisen.

In elektrischen Verbindern findet die Datenübertragung vorzugsweise auf differentiellen Leitungen statt. Eine differentielle Leitung weist eine erste Leiterbahn und eine zweite Leiterbahn auf. Die häufig als Plus-Leiterbahn oder Tip-Leiterbahn benannte Leiterbahn ist hier und im Folgenden die erste Leiterbahn, wohingegen die Minus-Leiterbahn oder auch Ring-Leiterbahn hier und im Folgenden als zweite Leiterbahn definiert ist. Auf der ersten Leiterbahn wird ein Signal übertragen, während die zweite Leiterbahn das invertierte Signal transmittiert. Der Empfänger bildet die Differenz zwischen den beiden Signalen, wobei die Differenz dem ursprünglichen zu übertragenden Signal entspricht. In elektrischen Verbindern besteht zwischen Leiterbahnen, insbesondere wenn diese nahe beieinander liegen, eine ungewünschte kapazitive Kopplung. Zudem besteht zwischen leitenden Kontaktflächen, insbesondere zwischen zweiten Kontaktelementen, welche vorzugsweise als Steckkontakte ausgebildet sind, eine ungewünschte elektromagnetische Kopplung. Steckkontakte sind große leitende Flächen, die in der Nähe zueinander angeordnet sind. Je näher die beiden Steckkontakte zueinander angeordnet sind und je größer die leitenden Flächen ausgebildet sind, umso größer ist die kapazitive Kopplung zwischen zwei Steckkontakten.

Eine ungewünschte kapazitive Kopplung zwischen einer ersten Leiterbahn und einer zweiten Leiterbahn unterschiedlicher differentieller Leitungen eins und zwei, kann dahingehend ausgeglichen werden, indem eine zusätzliche Kapazität zwischen den beiden ersten Leiterbahnen der zuvor betrachteten differentiellen Leitungen eins und zwei zwischen geschaltet wird. Die erste Leiterbahn der differentiellen Leitung zwei sieht nun zum einen das ungewünschte Übersprechen resultierend aus der ungewünschten kapazitiven Kopplung der zweiten Leiterbahn der differentiellen Leitung eins und der ersten Leiterbahn der differentiellen Leitung zwei und das gewünschte Übersprechen durch die zusätzlich eingefügte Kapazität zwischen den beiden ersten Leiterbahnen der differentiellen Leitungen eins und zwei. Da die erste Leiterbahn der zweiten differentiellen Leitung sowohl kapazitiv mit der ersten Leiterbahn als auch mit der zweiten Leiterbahn der differentiellen Leitung eins gekoppelt ist und die zu übertragenden Signale auf diesen Leiterbahnen invertiert zueinander sind, heben sich die Übersprechsignale bestenfalls auf. Bei elektrischen Verbindern muss die Kapazität dabei derart ausgelegt werden, dass das gewünschte Übersprechen gerade so groß ist, um das ungewünschte Übersprechen zu negieren oder in einem normativ festgelegten Bereich zu legen. Insbesondere ist das Übersprechen in Steckverbindern derart ausgelegt, dass der Steckverbinder in Verbindung mit einem komplementären elektrischen Verbinder, der in der Regel als Buchse ausgeführt ist, ein möglichst geringes Übersprechen aufweist. Die gute Buchse kompensiert den schlechten Steckverbinder. Selbiges gilt für alle weiteren Bauteile, insbesondere für Steckkontakte, welche eine ungewünschte kapazitive Kopplung zueinander aufweisen. Fällt die Kapazität gegebenenfalls zu groß aus, so muss sie mittels einer Gegenkapazität an anderer Stelle kompensiert werden. Die Gegenkapazität ist derart ausgebildet, dass diese mit denselben Leiterbahnen verbunden ist, wie die Leiterbahnen oder Steckkontakte zwischen denen das ungewünschte Übersprechen injiziert wird.

Erfindungsgemäß ist die Kapazität, welche das gewünschte Übersprechen injiziert, durch eine einzige Kapazitätsplatte und eine mit dieser Kapazitätsplatte kapazitiv gekoppelten Fläche bzw. Teilfläche des überlappenden Steckkontakts, ausgebildet, wodurch die Anordnung der eines Plattenkondensators gleicht. Diese Anordnung ist hier und im Folgenden als Kapazitätsanordnung definiert. Dadurch dass erfindungsgemäß lediglich eine einzige Kapazitätsplatte ausgebildet werden muss, ist der Platzbedarf für die Kapazitätsanordnung deutlich reduziert. Auf den Platinenlagen, auf der die Kapazitätsplatte nicht angeordnet ist, können so zum Beispiel Leiterbahnen verlaufen und kreuzen.

Zwischen der Kapazitätsplatte und der überlappenden Kapazitätsplatte des Steckkontakts ist, je nachdem auf welcher Platinenlage die Kapazitätsplatte ausgebildet ist, entweder nur Luft und das Trägerelement oder Luft und das Substrat der Platine und das Trägerelement angeordnet. Sowohl Luft als auch das Substrat der Platine als auch das Trägerelement sind dielektrisch. Eine der wesentlichsten physikalischen Eigenschaften eines Dielektrikums ist die relative Permittivität. Diese ist direkt proportional zur Kapazität. Für Luft ist die relative Permittivität sehr nahe bei eins, wohingegen die relative Permittivität des Substrats bei gängigen Materialien zwischen 3,2 und 5 liegt. Damit ist die Anordnung der Kapazitätsplatte auf unterschiedlichen Platinenlage ein weiterer Freiheitsgrad zum idealen Einstellen der Kapazität. Gängige Materialien für Platinen sind FR4 oder Polymid, wobei die relative Permittivität für Polymid typischerweise zwischen 3,2 bis 3,7 liegt und von FR4 zwischen 3,5 und 5 liegt. Das Trägerelement weist eine Permittivität von etwa 3,5 auf.

Der Kapazitätswert eines Plattenkondensators ist direkt proportional zur überlappenden Fläche des Steckkontakts und der Kapazitätsplatte und reziprok proportional zum Abstand der Kapazitätsplatte zur überlappenden Fläche des Steckkontakts. Erfindungsgemäß wird die Kapazitätsanordnung nahe an der Stelle angeordnet, an der das ungewünschte Übersprechen auftritt. Da das Übersprechen aufgrund der großen leitenden Flächen der Steckkontakte im Bereich der Kontaktstelle des Steckverbinders und einem komplementären elektrischen Verbinder besonders groß ist, wird die Kapazitätsanordnung in der Nähe dieser Steckkontakte angeordnet.

Bei den oben aufgeführten Abhängigkeitsverhältnissen ist die Annahme getroffen, dass sich zwischen den Platten des Kondensators ein homogenes elektrisches Feld ausbildet. Bei Anwendungen, in denen kein homogenes Feld angenommen werden kann, treten eventuell andere Abhängigkeiten auf. Insbesondere kann eine Linearität der Parameter Plattenfläche, Plattenabstand und relative Permittivität unter Umständen nicht mehr angenommen werden, was die Berechnung und Auslegung deutlich aufwändiger macht. Zudem sind die Anordnung der leitenden Platten zueinander sowie die Anordnung des Dielektrikums und das zugrundeliegende Modell für die Berechnung entscheidend.

Unter gewissen Umständen ist es nötig eine Störkapazität zwischen einer ersten Leiterbahn und einer zweiten Leiterbahn derselben differentiellen Leitung zu schalten, um die normativen Anforderungen an den elektrischen Verbinder zu erfüllen. Die Störkapazität verstärkt dabei künstlich das ungewünschte Übersprechen.

Vorteilhafterweise ist die Kapazitätsplatte über eine Stichleitung mit einer Leiterbahn verbunden.

Gemäß einer vorteilhaften Ausgestaltung der Erfindung ist eines der Kontaktelemente, vorzugsweise das zweite Kontaktelement, insbesondere wenn das zweite Kontaktelement als Stecckontakt ausgebildet ist, zumindest abschnittsweise parallel zur Kapazitätsplatte angeordnet. Damit vergrößert sich die überlappende Fläche der Kapazitätsanordnung und die Kapazität fällt größer aus. Dies ist notwendig, da die Kapazitätsanordnung teilweise Luft zwischen den leitenden Flächen ausgebildet hat, wobei Luft im Vergleich zum Substrat der Platine oder dem Trägerelement eine geringe Permittivität aufweist. Die geringe Permittivität muss durch größere überlappende Flächen der Kapazitätsanordnung ausgeglichen werden.

Vorteilhafterweise ist die Kapazitätsplatte vollständig überlappend zu dem Kontaktelement, vorzugsweise zu dem zweiten Kontaktelement, insbesondere wenn das zweite Kontaktelement als Steckkontakt ausgebildet ist, angeordnet oder ein Mittelteil des Steckkontakts ist vollständig überlappend zu der Kapazitätsplatte angeordnet.

Gemäß einer besonders bevorzugten Ausgestaltung der Erfindung ist die Kapazitätsplatte vorzugsweise mindestens eineinhalb Mal so breit wie die Breite der Leiterbahnabschnitte, welche direkt an den zweiten Kontaktpads angeschlossen sind. Zudem kann die Kapazitätsplatte mindestens zweimal, zweieinhalbmal, dreimal, viermal oder fünfmal so breit sein wie die Breite der Leiterbahnabschnitte, welche direkt an den zweiten Kontaktpads angeschlossen sind. Die Kapazitätsplatte kann mindestens eineinviertel, eineinhalb, zweimal, zweieinhalb, dreimal so breit sein, wie die breiteste oder dünnste Leiterbahnbreite auf der Platine, welche direkt im Signalpfad oder außerhalb des Signalpfades liegt. Als Signalpfad ist derjenige Pfad definiert, welcher ein erstes Kontaktelement und ein zweites Kontaktelement auf direktem Pfad miteinander verbindet.

Vorteilhafterweise ist die Platine als mehrlagige Platine ausgebildet. Dadurch kann die Kapazitätsplatte der Kapazitätsanordnung auf einer beliebigen Platinenlage angeordnet werden. Neben Platzmangel kann damit die Kapazität verändert werden, indem sich der Abstand und das Dielektrikumverhältnis verändert. Es können zweilagige, vierlagige, sechslagige oder achtlagige Platinen eingesetzt werden.

In einer vorteilhaften Weiterbildung der Erfindung ist die Kapazitätsplatte in einer der mittleren Lagen der mehrlagigen Platine ausgebildet oder die Kapazitätsplatte ist in einer der äußeren Lagen der mehrlagigen Platine ausgebildet.

Gemäß einer bevorzugten Ausgestaltung der Erfindung sind auf der Platine vier differentielle Leitungen ausgebildet. Jeweils eine erste und eine zweite Leiterbahn bilden eine differentielle Leitung aus. Die Leiterbahnen sind von eins bis acht definiert, wobei die Leiterbahnen eins und zwei, die Leiterbahnen drei und sechs, die Leiterbahnen vier und fünf und die Leiterbahnen sieben und acht jeweils eine differentielle Leitung ausbilden. Insbesondere die Leiterbahnen vier und fünf sowie die Leiterbahnen drei und sechs sind bei der Betrachtung des Übersprechens besonders herausfordernd. Ist der Kapazitätswert der Kapazitätsanordnung zu groß, so kann mit Hilfe von Gegenkapazitäten entgegen gesteuert werden. Solche Gegenkapazitäten können beispielsweise Kondensatoren sein, die zwischen die Leiterbahnen fünf und sechs oder drei und vier geschaltet werden. Die Impedanz der Leiterbahn ist von vielen Faktoren abhängig. Darunter fallen die Leiterbahnbreite, der Abstand der Leiterbahnen zueinander, die Leiterbahnhöhe, und die Substrateigenschaften. Durch Variation dieser Parameter ist eine Optimierung der Einfügedämpfung und der Rückflussdämpfung möglich, die wesentlichen Eigenschaften eines guten elektrischen Verbinders in der Hochfrequenztechnik sind.

Vorteilhafterweise ist die Kapazitätsplatte mit einer anderen differentiellen Leitung als das überlappende zweite Kontaktelement verbunden, welches vorzugsweise als Steckkontakt ausgebildet ist. Dadurch, dass die Signale auf den Leiterbahnen einer differentiellen Leitung mit umgekehrter Polarität übertragen werden, wird bei einer solchen Anordnung das Übersprechen negiert.

In einer besonders günstigen Ausgestaltung der Erfindung sind die Kapazitätsplatte mit der ersten Leiterbahn und das zweite Kontaktelement mit einer zweiten Leiterbahn derselben differentiellen Leitung verbunden. Eine derartige Anordnung wird dann verwendet, wenn die kapazitive Kopplung zwischen den Steckkontakten zu klein ist. Insbesondere bei Steckkontakten, die keine großen Kapazitätsplatten aufweisen, ist eine solche Maßnahme unter Umständen erforderlich.

In einer vorteilhaften Weiterbildung der Erfindung ist die Kapazitätsplatte mit einer ersten Leiterbahn einer differentiellen Leitung verbunden, wobei das zweite Kontaktelement ebenfalls mit einer ersten Leiterbahn einer anderen differentiellen Leitung verbunden ist. Das Kontaktelement ist vorzugsweise das zweite Kontaktelement, insbesondere wenn das zweite Kontaktelement als Steckkontakt ausgebildet ist. Die Kapazitätsplatte kann über eine Stichleitung mit dem zweiten Kontaktpad oder mit dem Leitungspfad verbunden sein. Dadurch verschieben sich die induktiven Anteile innerhalb einer Leiterbahn, wodurch die Einfügedämpfung und Rückflussdämpfung optimierbar ist. Die Kapazitätsplatte der Kapazitätsanordnung kann auch mit einem vorzugsweise zweiten Kontaktpad oder einem Leitungspfad verbunden sein.

Vorteilhafterweise ist die Kapazitätsplatte mit einer zweiten Leiterbahn einer differentiellen Leitung verbunden, wobei das überlappende zweite Kontaktelement, welches vorzugsweise als Steckkontakt ausgebildet ist, ebenfalls mit einer zweiten Leiterbahn einer anderen differentiellen Leitung verbunden ist.

In einer besonders bevorzugten Ausgestaltung der Erfindung ist die Kapazitätsplatte mit einer ersten Leiterbahn einer differentiellen Leitung verbunden, wobei das überlappende zweite Kontaktelement, welches vorzugsweise als Steckkontakt ausgebildet ist, mit einer zweiten Leiterbahn einer anderen differentiellen Leitung verbunden ist.

Gemäß einer günstigen Weiterbildung der Erfindung sind die zweiten Kontaktpads in zwei Reihen angeordnet, wobei die Reihen derart angeordnet sind, dass die Reihen einen unterschiedlichen Abstand zur Steckseite aufweisen, wobei die Reihen derart angeordnet sind, dass ein zweites Kontaktpad der einen Reihe zumindest teilweise zwischen zwei zweiten Kontaktpads der anderen Reihe angeordnet ist. Mit dieser Anordnung ist ein kompakterer Steckverbinder möglich. Die Steckverbinder werden an den zweiten Kontaktpads vorzugsweise verlötet, wobei diese zweiten Kontaktpads einen normativ vorgegeben Abstand zueinander aufweisen müssen. Damit werden die erforderlichen Kriechstecken und Überschlagsstrecken eingehalten. Bei einer derartigen Anordnung wird der erforderliche Abstand unter anderem durch Verschiebung der zweiten Kontaktpads in Richtung der Längsseite des Steckverbinders bewerkstelligt. Die Anordnung der zweiten Kontaktpads kann in einer Reihe angeordnet sein oder in mehr als zwei Reihen, insbesondere in einer geraden Anzahl von Reihen. Mit den unterschiedlichen Anordnungen der zweiten Kontaktpads ändert sich die Bauform des Steckkontakts, insbesondere wird der Mittelteil des Steckkontakts, je nach Anordnung des zweiten Kontaktpads, länger oder kürzer ausgebildet.

Vorteilhafterweise bildet die Kapazitätsplatte die Form eines Vierecks oder eines Ovals oder eines Kreises oder eines Dreiecks oder eines Parallelogramms, insbesondere um die normativen Abstände hinsichtlich Kriechstreckenabstand und Überschlagabstand einzuhalten und eine möglichst große überlappende Fläche mit dem Steckkontakt einzustellen.

Gemäß einer besonders bevorzugten Ausgestaltung der Erfindung ist das zweite Kontaktelement als Steckkontakt ausgebildet. Der Steckkontakt kann dabei u-förmig ausgebildet sein. Wobei der u-förmig ausgebildete Steckkontakt einen Fuß, einen Mittelteil und einen Überhang aufweist. Der Mittelteil verbindet Fuß und Überhang und ist vorzugsweise parallel zur Oberfläche der Platine bzw. entlang der Längsachse ausgebildet, wohingegen der Fuß und Überhang senkrecht zur Platine bzw. entlang der Querachse angeordnet sind. Der Fuß des Steckkontakts ist durch die zweite Kontaktdurchführung durchführbar und wird mittels einer Lötung oder einer Pressung elektrisch und mechanisch mit dem zweiten Kontaktpad kontaktiert.

Vorteilhafterweise sind die ersten Kontaktelemente als Schneidklemmen ausgebildet. Schneidklemmen, welche auch IDC genannt werden, zeichnen sich dadurch aus, dass eine schnelle und einfache Installation bewerkstelligbar ist. Die Drähte können mithilfe der Schneidklemmen elektrisch kontaktiert werden, ohne dass die Isolation gesondert entfernt werden muss, wodurch Zeit und die Fehleranfälligkeit sinkt. Zudem werden keine speziellen Werkzeuge zur Abisolierung der Drähte benötigt. Schneidklemmen zeichnen sich durch eine äußerst zuverlässige Verbindung aus. Beim Zusammensetzten durchschneiden die Klemmen der Schneidklemme die Isolierung, wodurch eine gasdichte Verbindung zwischen Draht und Schneidklemme entsteht und ein Eindringen von Feuchtigkeit und anderen Kontaminationen verhindert wird.

Überlappung ist im Vorherigen, hier und im Folgenden so definiert, dass mindestens ein Vektor existiert, der zwei im Raum angeordnete Flächen schneidet, wobei der Vektor eine der Flächen orthogonal schneidet. Die Flächen sind sodann überlappend zueinander angeordnet. Eine vollständige Überlappung ist gegeben, wenn es keinen Vektor gibt, der wenn er eine der beiden Flächen orthogonal schneidet, nicht auch die andere Fläche schneidet.

Die Vorderseite (Vorne) ist die Seite, die in einen anderen elektrischen Verbinder einführbar ist oder die Seite, in die ein anderer elektrischer Verbinder eingeführt wird. Die Steckseite liegt in der Vorderseite. Die Hinterseite (Hinten) ist die Seite, in die ein Anschlusskabel in den elektrischen Verbinder einführbar ist.

Die Längsachse ist diejenige Achse, die die Vorderseite und die Hinterseite orthogonal schneiden. Die Querachse ist diejenige Achse, die die Oberseite und Unterseite orthogonal schneiden. Eine Ebene ist eine unendlich ausgedehnte Fläche im dreidimensionalen Raum in zwei Raumrichtungen, wobei die Raumrichtung, die nicht die Fläche aufspannt, die Querachse charakterisiert. Die Querachse ist orthogonal zur Längsachse ausgebildet. Die Querachse schneidet die Oberseite (oben) und Unterseite (Unten). Die Querachse zeigt ausgehend vom Gehäuseunterteil in Richtung des Gehäuseoberteils. Der Höchste Punkt des elektrischen Verbinders spannt innerhalb einer Ebene der Querachse die Oberseite auf, wohingegen der niedrigste Punkt des elektrischen Verbinders die Unterseite innerhalb einer Ebene der Querachse aufspannt.

Eine Stichleitung ist eine Leitung, die nicht im Übertragungspfad angeordnet ist. Der Übertragungsweg ist der Pfad, über den ein über den elektrischen Steckverbinder übertragenes Signal auf direktem Weg transmittiert wird.

Im Folgenden wird ein Ausführungsbeispiel der Erfindung anhand von Figuren erläutert. Es zeigen:
- Fig. 1: eine perspektivische Ansicht des elektrischen Verbinders in Explosionsdarstellung, welcher ein Gehäuseoberteil, bestehend aus einem Ladestück und einem Trägerelement, ein Gehäuseunterteil, ein Metallgehäuse und eine Platine aufweist,
- Fig. 2: eine perspektivische Ansicht der Platine aus Fig. 1, auf welcher Schneidklemmen und Steckkontakte angeordnet sind,
- Fig. 3: eine Draufsicht auf die Platine aus Fig. 1, wobei die oberste Platinenlage durch durchgezogene und die darunterliegenden Platinenlagen durch gestrichelte Linien abgebildet ist,
- Fig. 4: eine perspektivische Ansicht einer zweiten Leiterbahn einer ersten differentiellen Leitung und einer zweiten Leiterbahn einer zweiten differentiellen Leitung mit Kontaktpads und daran angeschlossenen Stichleitungen mit Kapazitätsplatten,
- Fig. 5: eine Draufsicht auf die zweiten Leiterbahnen der ersten differentiellen Leitung und zweiten differentiellen Leitung aus Fig. 4.

In den nachfolgenden Figuren bezeichnen gleiche Bezugszeichen gleiche Teile mit gleicher Bedeutung.

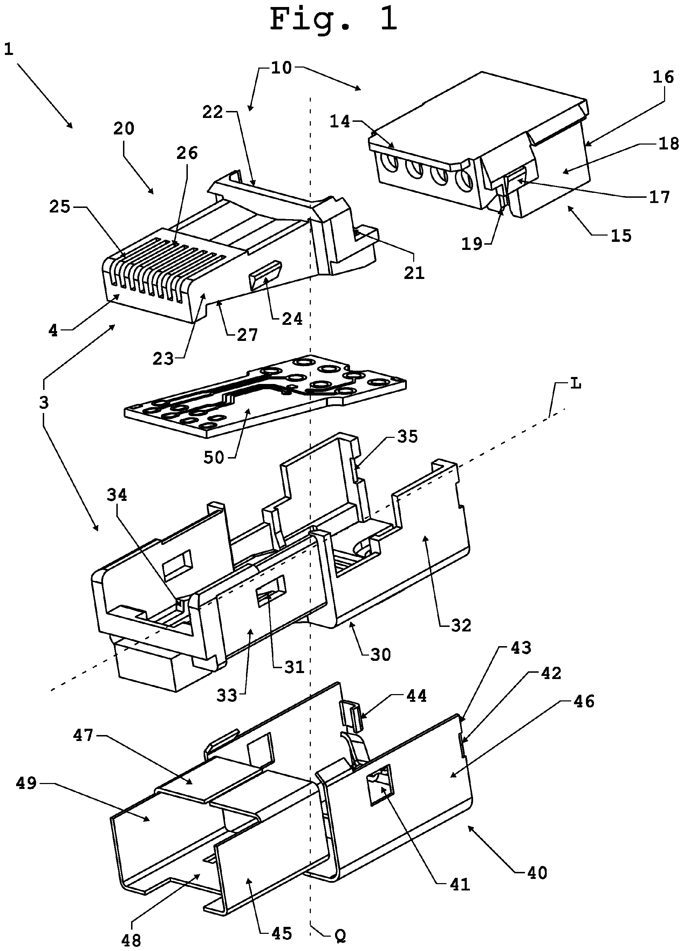

In Fig. 1 ist ein elektrischer Verbinder 1 aufgezeigt, welcher als Steckverbinder 1 ausgebildet ist. Der Steckverbinder 1 weist ein Gehäuse 3 auf, wobei das Gehäuse 3 aus einem Gehäuseoberteil 10 und einem Gehäuseunterteil 30 besteht. Sowohl Gehäuseunterteil 30 als auch Gehäuseoberteil 10 sind aus einem nicht leitenden Material, insbesondere aus Kunststoff, ausgebildet. Über dem Gehäuse 3 aus Kunststoff ist ein Metallgehäuse 40 angeordnet, um die elektromagnetische Verträglichkeit sowie die elektromagnetische Störaussendung zu reduzieren. Das Metallgehäuse 40 kann beispielsweise aus Blech oder einem Metalldruckgussteil, insbesondere einem Zinkdruckgussteil ausgebildet sein.

Das Gehäuseoberteil 10 weist ein Trägerelement 20 und ein Ladestück 15 auf. Das Ladestück 15 weist eine Kabeleinführseite 16 auf. Durch die Kabeleinführseite 16 ist ein Kabel (nicht gezeigt) einführbar. Ein Kabel besteht aus einer Vielzahl von Einzeladern, wobei diese Einzeladern, die zuvor beispielsweise paarweise verdrillt gewesen sein können, aufgetrennt und in die Halteklemmen des Ladestücks 15 eingesetzt und mechanisch fixiert werden. Die Einzeladern können mittels einer Schraube, eines Klebemittels oder vorzugsweise mittels einer Klemmung mechanisch am Ladestück 15 fixiert werden. Das Ladestück 15 weist Aushöhlungen auf, in welche z.B. Schneidklemmen beim Zusammensetzen eindringen und die Einzeladern des eingeführten Kabels abisolieren und eine elektrische Verbindung herstellen. Das Trägerelement 20 ist mit der Platine 50 verbunden, indem die im Trägerelement 20 sitzenden Steckkontakte 66 an die Platine 50 gelötet werden. Trägerelement 20 und Platine 50 sind im Gehäuse 3 einrastbar.

Das Ladestück 15 ist an dem Metallgehäuse 40 mittels einer Schnapp-Füge-Verbindung miteinander verbindbar. Hierfür weist das Ladestück 15 an seinen Seitenflächen 18 jeweils ein Haltemittel, welches vorzugsweise als Rastnase 17 ausgebildet ist, auf. Die Rastnase 17 greift in eine Ausnehmung 41 des Metallgehäuses 40 ein. Vorteilhaft an solchen Schnapp-Füge-Verbindungen ist, dass das Zusammensetzen sowie das Lösen der Teilkomponenten voneinander ohne Werkzeug bewerkstelligbar ist. Das Ladestück 15 weist Führungen 19 auf, welche in Ausnehmungen 21 des Trägerelements 20 einsetzbar sind und Trägerelement 20 und Ladestück 15 miteinander verbinden. Zudem weist das Ladestück 15 einen Überhang 14 auf, der sich beim Zusammensetzen von Ladestück 15 und Trägerelement 20 in eine Einbuchtung 22 des Trägerelements 20 einschmiegt.

Das Trägerelement 20 weist an den Seitenflächen 23 ein Haltemittel auf, welches vorzugsweise als Rastnase 24 ausgebildet ist und sich in eine Ausnehmung 31 des Gehäuseunterteils 30 einfügt. Damit wird das Gehäuseunterteil 30 und das Trägerelement 20 mittels einer Schnapp-Füge-Verbindung im zusammengesetzten Zustand zusammengehalten. Im Bereich der Steckseite 4 weist das Trägerelement 20 Schlitze 25 auf, welche L-förmig ausgebildet sind und sich ausgehend von der Steckseite 4 auf der Oberseite 26 des Trägerelements entlang der Längsachse L ausbilden. In die Schlitze 25 des Trägerelements 20 sind die Steckkontakte 66 einsetzbar oder eingesetzt. Die Unterkante 27 der Seitenflächen 23 des Trägerelements 20 sind entlang der Längsachse L in Richtung des Ladestücks 15 abfallend ausgebildet. Der Teil des Trägerelements 20, welcher direkt am Ladestück 15 angeordnet ist, ist entlang der Querachse Q, größer ausgebildet als der Teil des Trägerelements 20, welcher an der Stirnseite 4 ausgebildet ist.

Das Gehäuseunterteil 30 ist wannenförmig ausgebildet und in einen ersten Teilkörper 32 und in einen zweiten Teilkörper 33 unterteilbar. Das Gehäuseunterteil 30 ist vorzugsweise aus einem nicht leitenden Material ausgebildet, insbesondere aus Kunststoff. Der erste Teilkörper 32 weist ein größeres Innenvolumen als der zweite Teilkörper 33 auf. Das Ladestück 15 ist vornehmlich in den ersten Teilkörper 32 einsetzbar, wohingegen das Trägerelement 20 vornehmlich in den zweiten Teilkörper 33 einsetzbar ist. Innerhalb des Gehäuseunterteils 30 ist eine schräg zur Längsachse L verlaufende Auflagefläche 34 ausgebildet. Auf die Auflagefläche 34 ist die Platine 50 auflegbar. Die Platine 50 ist damit in Bezug auf die Längsachse L schräg im Gehäuse 3 angeordnet. Durch die schräge Anordnung der Platine 50 im Gehäuse 3, ist der Steckerverbinder 1 entlang der Längsachse L kürzer ausbildbar. Die Platine 50 weist gegenüber der Längsachse L einen Winkel auf. Die Platine 50 kann auch parallel oder orthogonal zur Längsachse L angeordnet sein.

Zwei Klemmvorrichtungen 42 sind an der Hinterseite 43 des Metallgehäuses 40 angeordnet. Die Klemmvorrichtungen 42 ragen in das Gehäuseinnere hinein und aufeinander zu. Die zwei Klemmvorrichtungen 42 weisen an deren Enden Haltenasen 44 auf, welche im zusammengesetzten Zustand in Aussparungen 35 des Gehäuseunterteils 30 eingreifen und das Metallgehäuse 40 und das Gehäuseunterteil 30 miteinander verbinden. Das Metallgehäuse 40 ist in einen ersten Teilbereich 45 und einen zweiten Teilbereich 46 unterteilt. Der zweite Teilbereich 46 ist wannenartig ausgebildet, wobei die freie Seite die Seite ist, die in Richtung Gehäuseoberteil 10 zeigt. Der erste Teilbereich 45 weist abschnittsweise ein Dach 47 auf. Der Abschnitt mit Dach 47 ist im Übergangsbereich von ersten Teilbereich 45 zum zweiten Teilbereich 46 angeordnet. Der restliche Abschnitt des ersten Teilbereichs 45 weist an dessen Oberseite eine Freifläche 49 auf. Der erste Teilbereich 45 und der zweite Teilbereich 46 sind über eine Metallplatte am jeweiligen Boden 48 miteinander verbunden. Die Metallplatte ist leicht federnd ausgebildet, sodass das Zusammenbauen des Steckverbinders 1 vereinfacht wird.

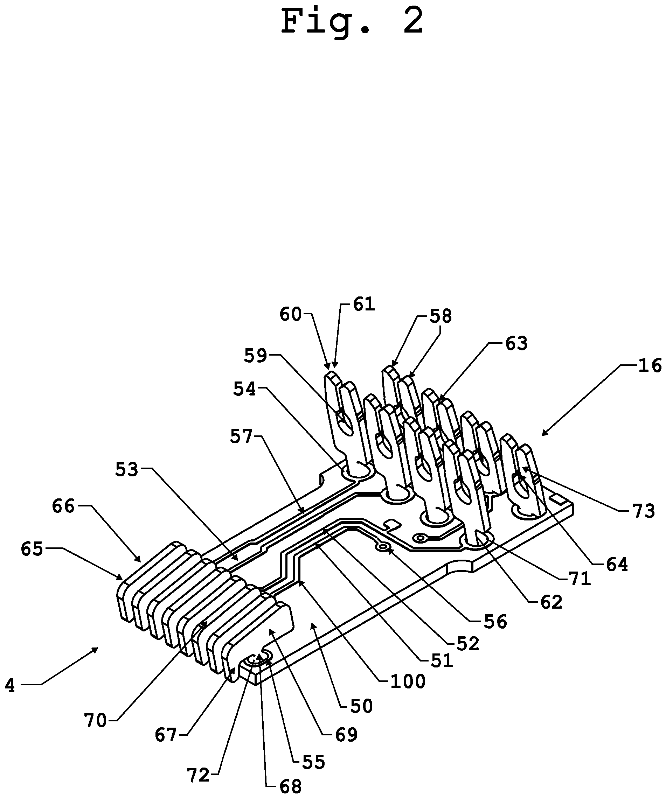

In Fig. 2 ist die Platine 50 aus Fig. 1 gezeigt. Die Platine 50 weist acht Leiterbahnen 100 auf, wobei zwischen ersten Leiterbahnen 51 und zweiten Leiterbahnen 52 unterschieden wird und vier Leiterbahnen 100 auf der Oberseite und die anderen vier Leiterbahnen 100 auf einem der anderen Platinenlagen verlaufen (nicht zu sehen). Jeweils eine erste Leiterbahn 51 und eine zweite Leiterbahn 52 bilden eine differentielle Leitung 53 aus. Die erste Leiterbahn 51 der differentiellen Leitung 53 ist als die gängig bezeichnete Plus- oder Tip-Leiterbahn definiert, wohingegen die zweite Leiterbahn 52 der differentiellen Leitung 53 als die gängig bezeichnete Negativ- oder Ring-Leiterbahn definiert ist. Jede der Leiterbahnen 100 weist ein erstes Kontaktpad 54 und ein zweites Kontaktpad 55 auf, wobei das erste Kontaktpad 54 und das zweite Kontaktpad 55 über einen Leitungspfad 57 miteinander verbunden sind. Die ersten Kontaktpads 54 sind um erste Durchführöffnungen 71 herum ausgebildet, wobei die zweiten Kontaktpads 55 um zweite Durchführöffnungen 72 ausgebildet sind, wobei die ersten 71 und zweiten Durchführöffnungen 72 an den Seitenflächen vorzugsweise verkupfert sind. Das erste Kontaktpad 54 und zweite Kontaktpad 55 kann auf mehreren Platinenlagen ausgebildet sein, wobei die verkupferten Seitenflächen der ersten 71 und zweiten Durchführöffnung 72 Teil der ersten 54 und zweiten Kontaktpads 55 sind. Die ersten 54 und zweiten Kontaktpads 55 können dabei die Form eines Kreises, eines Ovals, eines Vielecks, insbesondere eines Vierecks aufweisen.

Jede der Leiterbahnen 100 verbindet ein erstes Kontaktelement 60, welches vorzugsweise als Schneidklemme 61 ausgebildet ist und ein zweites Kontaktelement 65, welches vorzugsweise als Steckkontakt 66 ausgebildet ist, miteinander. Eine Leiterbahn 100 kann auf mehr als einer Platinenlage verlaufen. Hierbei sind die einzelnen Leitungsabschnitte auf den unterschiedlichen Platinenlagen durch Vias 56 miteinander verbunden. Die Schneidklemmen 61 sind in Nähe der Kabeleinführseite 16 angeordnet, wobei die Steckkontakte 66 in der Nähe der Steckseite 4 angeordnet sind. Die Schneidklemmen 61 und die Steckkontakte 66 zeigen in Richtung Gehäuseoberteil 20. Die Schneidklemme 61 weist einen Fuß 62 auf, der durch die erste Durchführöffnung 71 durchführbar ist. Der Fuß 62 der Schneidklemme 61 wird mittels einer Lötung oder einer Pressung mit dem ersten Kontaktpad 54 elektrisch und mechanisch kontaktiert. Die Schneidklemme 61 weist in dessen Mitte ein Loch 59 auf, in welches über eine Öffnung 63 eine Einzelader des einzuführenden Kabels eindrückbar ist. Beim Eindrücken sind die Einzeladern im Ladestück 15 angeordnet. Die Isolierung der Einzeladern wird von den Klemmelementen 58 der Schneidklemme 61 abisoliert und es entsteht eine elektrische Verbindung zwischen Schneidklemme 61 und Einzelader. An der Schneidklemme 61 angeordnete Nasen 64 verhindern, dass die Einzelader des Kabels aus dem Loch 59 der Schneidklemme 61 herausrutschten kann. Der Fuß 62 der Schneidklemme 61 ragt auf der dem Gehäuseunterteil 30 zugewandten Seite der Platine 50 heraus.

Die Schneidklemmen 61 sind in zwei Reihen angeordnet, wobei eine Reihe dadurch charakterisiert ist, dass die Füße 62 der Schneidklemmen 61 einer Reihe von der Steckseite 4 des Steckverbinders 2 gleich weit angeordnet sind. Die Schneidklemmen 61 können in einer Reihe oder in mehr als zwei Reihen angeordnet sein, beispielsweise in drei, vier oder fünf Reihen. Die Schneidklemmenflächen 73 sind vorliegend parallel zueinander ausgerichtet. Die Schneidklemmenflächen 73 unterschiedlicher Reihen, können einen Winkel zueinander aufweisen. Die Schneidklemmenflächen 73 von Schneidklemmen einer Reihe können unterschiedliche Winkel zueinander aufweisen. Die Schneidklemmenflächen 73 können senkrecht aufeinander stehen. Die Schneidklemmen 61 einer Reihe können eine andere Höhe wie die Schneidklemmen 61 einer anderen Reihe aufweisen. Dadurch kann Bauraum gespart werden, da die Einzeladern übereinander in dem Ladestück 15 angeordnet werden.

Die Steckkontakte 66 weisen jeweils einen Fuß 68 auf. Die Steckkontakte 66 ragen über die Platine 50 hinaus. Der der Steckseite 4 am nächsten angeordnete Teil der Steckkontakte 66, verläuft parallel zum Fuß 68 des Steckkontakts und würde die Platine 50 auf einer weiter gedachten Linie senkrecht schneiden. Dieser Bereich ist als Überhang 67 definiert. Der Bereich, der Überhang 67 und Fuß 68 miteinander verbindet ist der Mittelteil 69 des Steckkontakts 66. Der Mittelteil 69 des Steckkontakts 66 ragt über den Fuß 68 in Richtung Platinenmitte. Der Überhang 67 aller Steckkontakte 66 ist in einer Reihe angeordnet, wobei die Füße 68 der Steckkontakte 66 in zwei Reihen angeordnet sind. Die Füße der Steckkontakte 66 können in einer Reihe oder in mehr als zwei Reihen angeordnet sein. Der Mittelteil 69 sowie Teilabschnitte des Überhangs 67 gehören zur Kontaktstelle 70, wobei an der Kontaktstelle 70 der Steckverbinder 1 mit einer komplementären Buchse (nicht gezeigt) im zusammengesteckten Zustand miteinander verbunden wird. Die Steckkontakte 66 sind u-förmig ausgebildet. Zudem können die Steckkontakte 66 ein Metallplättchen aufweisen, an dem ein Fuß 62 angeordnet ist. Das Metallplättchen ist vorzugsweise viereckig ausgebildet und weist in der Mitte des Metallplättchens ein Loch auf. Der Durchmesser des Loches bestimmt unter anderem die kapazitive Kopplung der Steckkontakte 66 zueinander. Der Steckkontakt 66 kann zudem zwei oder drei Füße 68 aufweisen. Mit jedem der Füße 68 kann eine Stichleitung 84 verbunden sein, die wiederrum mit einer Kapazitätsplatte 91 verbunden ist, die mit dem Steckkontaktakt 66 überlappend angeordnet ist.

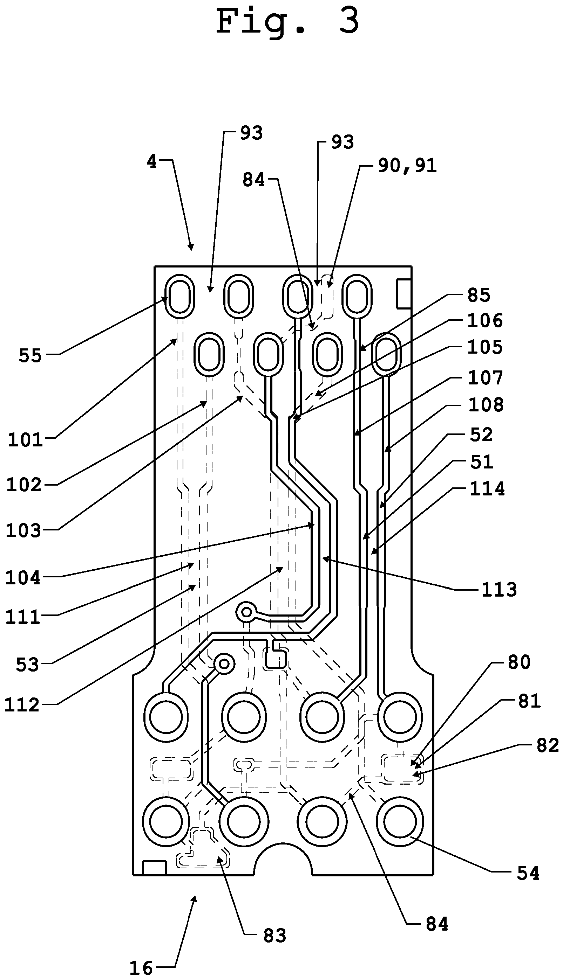

In Fig. 3 ist eine Draufsicht auf die Platine 50 aus Fig. 1 gezeigt. Die durchgezogenen Striche zeigen die elektrischen Elemente auf der obersten Platinenlage, wobei die gestrichelten Linien, die elektrischen Elemente auf den darunterliegenden Lagen aufzeigen. Die Platine 50 ist als mehrlagige Platine 50, vorzugsweise als vierlagige Platine 50, ausgebildet. Die Platine 50 kann zwei oder mehr als vier Platinenlagen aufweisen. Die zweiten Kontaktpads 55 sind in zwei Reihen angeordnet, wobei jede Reihe aus vier zweiten Kontaktpads 55 besteht. Zwischen zwei zweiten Kontaktpads 55 der einen Reihe ist ein zweites Kontaktpad 55 der anderen Reihe zumindest teilweise angeordnet. Damit ist zwischen den zweiten Kontaktpads 55 einer Reihe eine Freifläche 93 ausgebildet. In diese Freifläche 93 ist eine Kapazitätsplatte 91 einer Kapazitätsanordnung 90 angeordnet. Die Kapazitätsplatte 91 ist über eine Stichleitung 84 mit einer zweiten Leiterbahn 52 verbunden. Die Kapazitätsplatte 91 kann dabei in den äußeren oder in den mittleren Platinenlagen angeordnet sein. Durch die veränderbare Anordnung der Kapazitätsplatte 91 auf der Platine 50 ist der Kapazitätswert der Kapazitätsanordnung 90 veränderbar. Die Kapazitätsanordnung 90 ist in der Nähe der Steckseite 4 ausgebildet. Die Kapazitätsplatte 91 kann zwischen den zweiten Kontaktpads 55 näher oder weiter zu der Steckseite 4 als die zweiten Kontaktpads 55 angeordnet sein. Die Kapazitätsplatte 91 kann zwischen den zweiten Kontaktpads 55 der ersten Reihe oder zwischen den zweiten Kontaktpads 55 der zweiten Reihe angeordnet sein. Die zweiten Kontaktpads 55 können in einer Reihe oder in mehr als zwei Reihen angeordnet sein. Die zwischen den zweiten Kontaktpads 55 verlaufenden Leiterbahnen 100 weisen Verjüngungen 85 auf, um den normativen Abstand zu den zweiten Kontaktpads 55 einzuhalten oder die Impedanz der Leiterbahnen 100 zu verändern.

Die ersten 51 und zweiten Leiterbahnen 52 einer differentiellen Leitung 53 verlaufen auf der Platine 50 über weite Bereiche parallel zueinander, womit der Abstand zwischen den Leiterbahnen 100 in einem weiten Bereich gleichbleibend ausgebildet ist. Zudem ist die Leiterbahnbreite der Leiterbahnen 100 veränderbar. Sowohl durch den veränderbaren Abstand zweier Leiterbahnen 100 zueinander als auch die Leiterbahnbreite ist die Impedanz anpassbar. Damit kann die Einfügedämpfung und die Rückflussdämpfung optimiert werden.

Die acht auf der Platine 50 angeordneten Leiterbahnen 100, weisen vier erste Leiterbahnen 51 und vier zweite Leiterbahnen 52 auf. Die vier ersten Leiterbahnen 51 sind als die Leiterbahn eins 101, Leiterbahn drei 103, Leiterbahn fünf 105 und Leiterbahn sieben 107 definiert, wohingegen die zweiten Leiterbahnen 52 als die Leiterbahn zwei 102, Leiterbahn vier 104, Leiterbahn sechs 106 und Leiterbahn acht 108 definiert sind. Die Leiterbahn eins 101 und die Leiterbahn zwei 102 bilden eine differentielle Leitung eins 111 aus. Die Leiterbahn drei 103 und die Leiterbahn sechs 106 bilden eine differentielle Leitung zwei 112 aus. Die Leiterbahn vier 104 und die Leiterbahn fünf 105 bilden eine differentielle Leitung drei 113 aus und die Leiterbahn sieben 107 und die Leiterbahn acht 108 bilden eine differentielle Leitung vier 114 aus.

Insgesamt weist die Platine 50 sechs Kompensationseinheiten 80 auf, wobei fünf der Kompensationseinheiten 80 als Kondensatoren 81, vorzugsweise als Plattenkondensatoren 82 ausgebildet sind. Die Platten 83 der Plattenkondensatoren 82 sind vorzugsweise viereckig und nahezu vollständig überlappend zueinander angeordnet. Die Platten 83 können allerdings auch vieleckig, rund oder oval ausgebildet sein. Die Platten 83 der Plattenkondensatoren 82 sind zum Beispiel über Stichleitungen 84 mit einer Leiterbahn 100 verbunden. Die Platten 83 der Plattenkondensatoren 82 können auch direkt mit einer Leiterbahn 100 verbunden sein. Einer der fünf Plattenkondensatoren 82 ist zwischen der Leiterbahn eins 101 und Leiterbahn drei 103 geschaltet. Ein anderer Plattenkondensator 82 ist zwischen die Leiterbahn eins 101 und die Leiterbahn vier 104 zwischen geschaltet. Ein anderer Plattenkondensator 82 ist zwischen die Leiterbahn zwei 102 und die Leiterbahn acht 108 geschaltet. Ein anderer Plattenkondensator 82 ist zwischen die Leiterbahn drei 103 und die Leiterbahn acht 108 geschaltet. Ein anderer Plattenkondensator 82 ist zwischen die Leiterbahn fünf 105 und die Leiterbahn sieben 107 geschaltet. Die Plattenkondensatoren 82 können ebenfalls als Interdigitalkondensatoren ausgebildet sein.

Die sechste Kompensationseinheit 80 ist die Kapazitätsanordnung 90, die sich aus einer Kapazitätsplatte 91 und dem Stecckontakt 66 zusammensetzt. Vorzugsweise ist diese Kapazitätsanordnung 90, bestehend aus einer Kapazitätsplatte 91 und dem Steckkontakte 66, zwischen den Leiterbahnen drei und fünf und vier und sechs angeordnet. Die Kapazitätsanordnung 90 kann allerdings auch zwischen allen anderen Leiterbahnen 100 angeordnet sein.

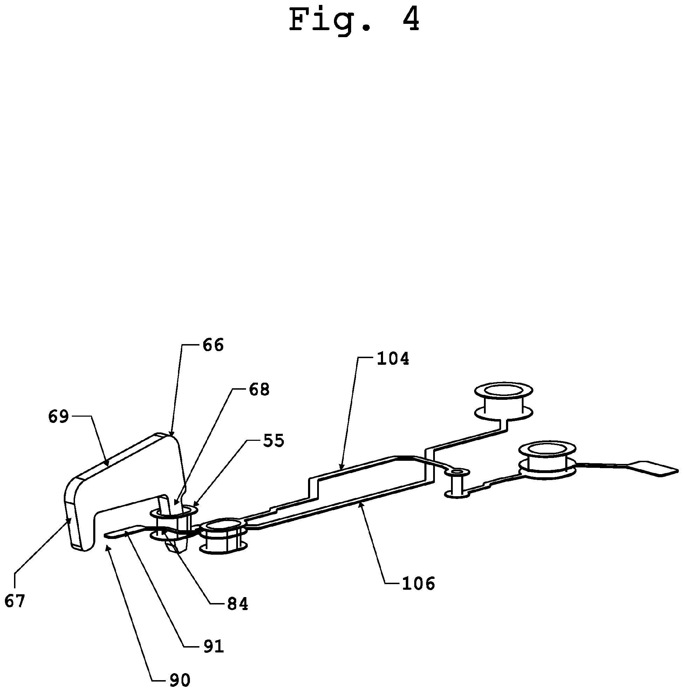

In Fig. 4 ist die Leiterbahn vier 104 der differentiellen Leitung drei 113 und die Leiterbahn sechs 106 der differentiellen Leitung zwei 112 losgelöst von den anderen Schaltungselementen in perspektivischer Ansicht gezeigt. Mit der Leiterbahn sechs 106 der differentiellen Leitung zwei 112 ist ein Steckkontakt 66 verbunden. Mit der Leiterbahn vier 104 ist die Kapazitätsplatte 91 der Kapazitätsanordnung 90 über eine Stichleitung 84 verbunden. Die Stichleitung 84 ist mit einem zweiten Kontaktpad 55 verbunden kann aber auch mit dem Leitungspfad 57 der zweiten Leiterbahn 52 verbunden sein. Die Kapazitätsplatte 91 ist derart auf der Platine 50 angeordnet, dass diese mit dem Steckkontakt 66 zumindest teilweise überlappend ist. Die Kapazitätsplatte 91 kann dabei in jeder Platinenlage angeordnet werden.

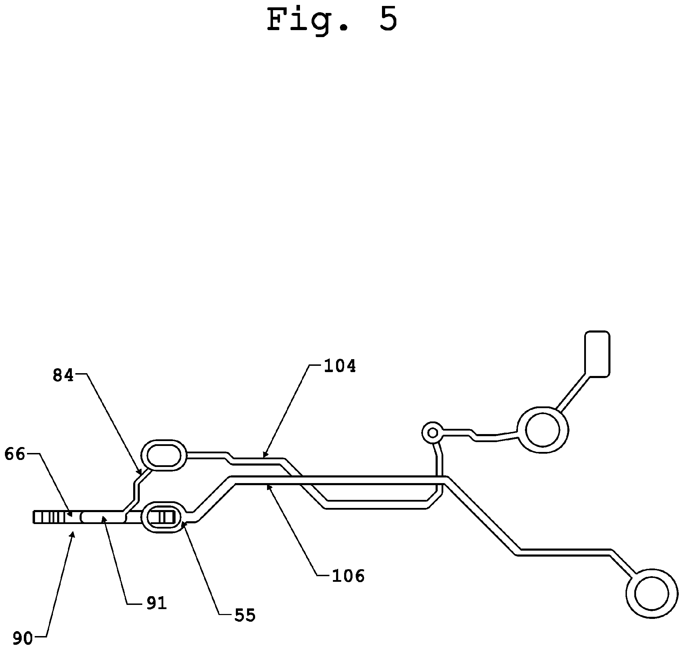

In Fig. 5 ist die Leiterbahn vier 104 der differentiellen Leitung drei 113 und die Leiterbahn sechs 106 der differentiellen Leitung zwei 112 in Draufsicht gezeigt. Die Kapazitätsplatte 91 der Kapazitätsanordnung 90 ist mit dem Steckkontakt 66 vollständig überlappend angeordnet. Die Kapazitätsplatte 91 ist über die Stichleitung 84 mit dem Leitungspfad 57 verbunden. Die Kapazitätsplatte 91 kann aber auch nur teilweise überlappend zu dem Steckkontakt 66 angeordnet sein. Die Kapazitätsplatte 91 kann zudem mit jeder anderen ersten Leiterbahn 51 einer differentiellen Leitung 53 und der überlappende Steckkontakt 66 mit jeder anderen zweiten Leiterbahn 52 einer gleichen oder anderen differentiellen Leitung 53 verbunden sein oder vice versa.

### Bezugszeichenliste

- 1: Elektrischer Verbinder
- 3: Gehäuse
- 4: Steckseite
- 10: Gehäuseoberteil
- 14: Überhang
- 15: Ladestück
- 16: Kabeleinführseite
- 17: Rastnase
- 18: Seitenfläche
- 19: Führungen
- 20: Trägerelement
- 21: Ausnehmung
- 22: Einbuchtung
- 23: Seitenfläche
- 24: Rastnase
- 25: Schlitz
- 26: Oberfläche
- 27: Unterkante
- 30: Gehäuseunterteil
- 31: Ausnehmung
- 32: Erster Teilkörper
- 33: Zweiter Teilkörper
- 34: Auflagefläche
- 35: Aussparung
- 40: Metallgehäuse
- 41: Ausnehmung
- 42: Klemmvorrichtung
- 43: Hinterseite
- 44: Haltenase
- 45: Erster Teilbereich
- 46: Zweiter Teilbereich
- 47: Dach
- 48: Boden
- 49: Freifläche
- 50: Platine
- 51: Erste Leiterbahn
- 52: Zweite Leiterbahn
- 53: Differentielle Leitung
- 54: Erstes Kontaktpad
- 55: Zweites Kontaktpad
- 56: Via
- 57: Leitungspfad
- 58: Klemmelement
- 59: Loch
- 60: Erste Kontaktelemente
- 61: Schneidklemme
- 62: Fuß
- 63: Öffnung
- 64: Nase
- 65: Zweite Kontaktelemente
- 66: Steckkontakt
- 67: Überhang
- 68: Fuß
- 69: Mitteilteil
- 70: Kontaktstelle
- 71: Erste Durchführöffnung
- 72: Zweite Durchführöffnung
- 73: Schneidklemmenfläche
- 80: Kompensationseinheiten
- 81: Kondensatoren
- 82: Plattenkondensatoren
- 83: Platten
- 84: Stichleitung
- 85: Verjüngung
- 90: Kapazitätsanordnung
- 91: Kapazitätsplatte
- 93: Freifläche

- 100: Leiterbahn
- 101: Leiterbahn eins
- 102: Leiterbahn zwei
- 103: Leiterbahn drei
- 104: Leiterbahn vier
- 105: Leiterbahn fünf
- 106: Leiterbahn sechs
- 107: Leiterbahn sieben
- 108: Leiterbahn acht

- 111: Differentielle Leitung eins
- 112: Differentielle Leitung zwei
- 113: Differentielle Leitung drei
- 114: Differentielle Leitung vier

- L: Längsachse
- Q: Querachse

## Patentansprüche

1. Elektrischer Verbinder (1) für ein Daten- oder Kommunikationskabel mit folgenden Merkmalen:
- einem Gehäuse (3),
- einer Platine (50), wobei die Platine (50) zumindest teilweise im Gehäuse (3) angeordnet ist,
- die Platine (50) weist mindestens eine differentielle Leitung (53) auf,
- die differentielle Leitung (53) weist eine erste Leiterbahn (51) und eine zweite Leiterbahn (52) auf,
- die erste (51) und zweite Leiterbahn (52) weisen jeweils einen Leitungspfad (57) und erste Kontaktpads (54) und zweite Kontaktpads (55) an den Enden des Leitungspfades (57) auf,
- die zweiten Kontaktpads (55) sind mit zweiten Kontaktelementen (65) elektrisch verbunden,
- mindestens eine Kapazitätsplatte (91) ist auf der Platine (50) ausgebildet,
**gekennzeichnet durch** die weiteren Merkmale:
- eine einzige Kapazitätsplatte (91) ist zumindest teilweise überlappend mit einem der zweiten Kontaktelemente (65) auf der Platine (50) ausgebildet, wobei die Kapazitätsplatte (91) nicht mit dem überlappenden zweiten Kontaktelement (65) elektrisch verbunden ist.

2. Elektrischer Verbinder (1) nach Anspruch 1, **dadurch gekennzeichnet, dass** die Kapazitätsplatte (91) über eine Stichleitung (84) mit einer Leiterbahn (100) verbunden ist.

3. Elektrischer Verbinder (1) nach Anspruch 1 oder 2, **dadurch gekennzeichnet, dass** eines der zweiten Kontaktelemente (65) zumindest abschnittsweise parallel zur Kapazitätsplatte (91) angeordnet ist.

4. Elektrischer Verbinder (1) nach einem der vorherigen Ansprüche, **dadurch gekennzeichnet, dass** die Kapazitätsplatte (91) vollständig überlappend zu dem zweiten Kontaktelement (65) angeordnet ist oder dass ein Mittelteil (69) des zweiten Kontaktelements (65) vollständig überlappend zu der Kapazitätsplatte (91) angeordnet ist.

5. Elektrischer Verbinder (1) nach einem der vorherigen Ansprüche, **dadurch gekennzeichnet, dass** die Kapazitätsplatte (91) mindestens eineinhalb Mal so breit ausgebildet ist wie die Breite der Leiterbahnabschnitte, welche direkt an zweiten Kontaktpads (55) angeschlossen sind.

6. Elektrischer Verbinder (1) nach einem der vorherigen Ansprüche, **dadurch gekennzeichnet, dass** die Platine (50) als mehrlagige Platine (50) ausgebildet ist.

7. Elektrischer Verbinder (1) nach Anspruch 5, **dadurch gekennzeichnet, dass** die Kapazitätsplatte (91) in einer der mittleren Lagen der mehrlagigen Platine (50) ausgebildet ist oder die Kapazitätsplatte (91) in einer der äußeren Lagen der mehrlagigen Platine (50) ausgebildet ist.

8. Elektrischer Verbinder (1) nach einem der vorherigen Ansprüche, **dadurch gekennzeichnet, dass** auf der Platine (50) vier differentielle Leitungen (53) ausgebildet sind.

9. Elektrischer Verbinder (1) nach einem der vorherigen Ansprüche, **dadurch gekennzeichnet, dass** die Kapazitätsplatte (91) mit einer anderen differentiellen Leitung (53) als das überlappende zweite Kontaktelement (65) verbunden ist.

10. Elektrischer Verbinder (1) nach einem der vorherigen Ansprüche, **dadurch gekennzeichnet, dass** die Kapazitätsplatte (91) mit der ersten Leiterbahn (51) und das zweite Kontaktelement (65) mit der zweiten Leiterbahn (52) derselben differentiellen Leitung (53) verbunden ist.

11. Elektrischer Verbinder (1) nach einem der vorherigen Ansprüche, **dadurch gekennzeichnet, dass** die Kapazitätsplatte (91) mit einer ersten Leiterbahn (51) einer differentiellen Leitung (53) verbunden ist, wobei das überlappende zweite Kontaktelement (65) ebenfalls mit einer ersten Leiterbahn (51) einer anderen differentiellen Leitung (53) verbunden ist.

12. Elektrischer Verbinder (1) nach einem der vorherigen Ansprüche, **dadurch gekennzeichnet, dass** die Kapazitätsplatte (91) mit einer zweiten Leiterbahn (52) einer differentiellen Leitung (53) verbunden ist, wobei das überlappende zweite Kontaktelement (65) ebenfalls mit einer zweiten Leiterbahn (52) einer anderen differentiellen Leitung (53) verbunden ist oder vice versa.

13. Elektrischer Verbinder (1) nach einem der vorherigen Ansprüche, **dadurch gekennzeichnet, dass** die Kapazitätsplatte (91) mit einer ersten Leiterbahn (51) einer differentiellen Leitung (53) verbunden ist, wobei das überlappende zweite Kontaktelement (65) mit einer zweiten Leiterbahn (52) einer anderen differentiellen Leitung (53) verbunden ist.

14. Elektrischer Verbinder (1) nach einem der vorherigen Ansprüche, **dadurch gekennzeichnet, dass** die zweiten Kontaktpads (55) in zwei Reihen angeordnet sind, wobei die Reihen derart angeordnet sind, dass die Reihen einen unterschiedlichen Abstand zur Steckseite (4) aufweisen, wobei die Reihen derart angeordnet sind, dass ein zweites Kontaktpad (55) der einen Reihe zumindest teilweise zwischen zwei zweiten Kontaktpads (55) der anderen Reihe angeordnet ist.

15. Elektrischer Verbinder (1) nach einem der vorherigen Ansprüche, **dadurch gekennzeichnet, dass** die Kapazitätsplatte (91) die Form eines Vierecks oder eines Ovals oder eines Kreises oder eines Dreiecks oder eines Parallelogramms ausbildet.

16. Elektrischer Verbinder nach einem der vorherigen Ansprüche, **dadurch gekennzeichnet, dass** das zweite Kontaktelement (65) als Steckkontakt (66) ausgebildet ist, wobei der Steckkontakt (66) U-förmig ausgebildet ist.
